# EUROPEAN PATENT APPLICATION

(11) **EP 3 783 130 A1**
(43) Date of publication of application: **24.02.2021**
(21) Application number: 19788720.1
(22) Date of filing: 08.04.2019
(51) Int. Cl.: C23C 16/40, C07F 3/02, C23C 16/455, H01L 21/316

(54) **SOURCE MATERIAL FOR THIN FILM FORMATION FOR ATOMIC LAYER DEPOSITION AND METHOD FOR PRODUCING THIN FILM**

(30) Priority: 20.04.2018 JP 2018081484
(71) Applicant: ADEKA CORPORATION, Arakawa-ku Tokyo 116-8554 (JP)
(72) Inventor: ENZU, Masaki, Tokyo 116-8554 (JP); TAKEDA, Keisuke, Tokyo 116-8554 (JP); NISHIDA, Akihiro, Tokyo 116-8554 (JP)
(74) Representative: Kador & Partner PartG mbB
(86) International application number: PCT/JP2019/015266
(87) International publication number: WO 2019/203035

(57) **Abstract**

Provided is a thin-film forming raw material, which is used in an atomic layer deposition method, including a magnesium compound represented by the following general formula (1): 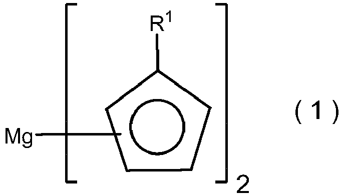 where R¹ represents an isopropyl group, a sec-butyl group, or a tert-butyl group. A thin-film containing a magnesium atom is produced on a surface of a substrate with high productivity through use of the raw material.

## Description

### Technical Field

The present invention relates to a thin-film forming raw material, which is used in an atomic layer deposition method containing a magnesium compound having a specific structure, and a method of producing a thin-film through use of the raw material.

### Background Art

Magnesium is used as a component for forming a compound semiconductor, and various raw materials have been reported as a thin-film forming raw material to be used in producing a thin-film thereof.

As a method of producing a thin-film, there are given, for example, a sputtering method, an ion plating method, an MOD method, such as a coating thermal decomposition method and a sol-gel method, and a CVD method. Of those, an atomic layer deposition method (sometimes called an ALD method) is an optimum production process because the atomic layer deposition method has a number of advantages, such as excellent composition controllability and step coverage, suitability for mass production, and capability of hybrid integration.

Various materials that can be used in vapor phase thin-film formation methods, such as the CVD method and the ALD method, have been reported. However, a raw material for thin-film formation applicable to the ALD method is required to have a temperature region called an ALD window, and the temperature region is required to be sufficiently wide. Therefore, it is common general technical knowledge in the art that even a raw material for thin-film formation, which can be used in the CVD method, may not be suitable for the ALD method in many cases.

In Patent Document 1, as a magnesium compound used in the CVD method, there is disclosed a magnesium raw material for vapor phase growth containing bis(substituted cyclopentadienyl)magnesium as a main component. In addition, in Patent Document 2, there are disclosed various magnesium compounds that can be used in the CVD method and the ALD method.

### Citation List

### Patent Document

Patent Document 1: JP H07-074108 A
Patent Document 2: US 2012/308739 A1

### Summary of Invention

### Technical Problem

The thin-film forming raw material, which is used in an atomic layer deposition method is required to be excellent in thermal stability, and react with a reactive gas at low temperature so that a thin-film can be produced with high productivity. However, in Patent Document 1, there is no description as to the ALD method, and there is no specific description as to whether the magnesium compound is applicable to the ALD method. In Patent Document 2, there are given various magnesium compounds and known thin formation methods, but there are merely described specific examples in which the magnesium compounds are applied to the CVD method.

Thus, the present invention has an object to provide a thin-film forming raw material which is used in an atomic layer deposition method, which is excellent in thermal stability, and reacts with a reactive gas at low temperature so that a magnesium-containing thin-film can be produced with high productivity, and a method of producing a thin-film through use of the raw material.

### Solution to Problem

The present inventors have carried out investigations and discovered that the abovementioned problems can be solved by a thin-film forming raw material, which is used in an atomic layer deposition method, containing a magnesium compound having a specific structure, to achieve the present invention.

That is, according to one embodiment of the present invention, there is provided a thin-film forming raw material, which is used in an atomic layer deposition method, including a magnesium compound represented by the following general formula (1) : 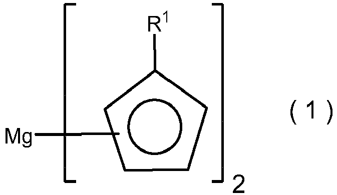 where R¹ represents an isopropyl group, a sec-butyl group, or a tert-butyl group.

In addition, according to one embodiment of the present invention, there is provided a method of producing a thin-film containing a magnesium atom on a surface of a substrate, the method including the steps of: vaporizing the thin-film forming raw material, which is used in an atomic layer deposition method, including a magnesium compound represented by the general formula (1) above and depositing the thin-film forming raw material, which is used in an atomic layer deposition method on the surface of the substrate, to thereby form a precursor thin-film; and subjecting the precursor thin-film to a reaction with a reactive gas, to thereby form the thin-film containing a magnesium atom on the surface of the substrate.

### Advantageous Effects of Invention

According to the present invention, the thin-film forming raw material, which is used in an atomic layer deposition method, which is excellent in thermal stability, and reacts with a reactive gas at low temperature so that a magnesium atom-containing thin-film can be produced with high productivity, can be provided. In addition, according to the present invention, the method of producing a magnesium-containing thin-film with high productivity by an atomic layer deposition method can be provided.

### Brief Description of Drawings

FIG. 1 is a schematic diagram for illustrating an example of an apparatus, which is used in an atomic layer deposition method to be used in a method of producing a thin-film according to the present invention.
FIG. 2 is a schematic diagram for illustrating another example of the apparatus, which is used in an atomic layer deposition method to be used in the method of producing a thin-film according to the present invention.
FIG. 3 is a schematic diagram for illustrating still another example of the apparatus, which is used in an atomic layer deposition method to be used in the method of producing a thin-film according to the present invention.
FIG. 4 is a schematic diagram for illustrating yet still another example of the apparatus, which is used in an atomic layer deposition method to be used in the method of producing a thin-film according to the present invention.

### Description of Embodiments

A thin-film forming raw material, which is used in an atomic layer deposition method of the present invention is characterized by containing a magnesium compound represented by the above-mentioned general formula (1).

In the general formula (1), R¹ represents an isopropyl group, a sec-butyl group, or a tert-butyl group. A plurality of R¹s may be identical to each other or different from each other.

A compound in which R¹ represents a sec-butyl group or a tert-butyl group in the general formula (1) is preferred because the following effects are particularly high: the compound has a low melting point, has high thermal stability, and reacts with an oxidizing gas at low temperature so that a thin-film containing magnesium can be formed with high productivity. Of those, a compound in which R¹ represents a sec-butyl group in the general formula (1) is particularly preferred because those effects are particularly high.

Specific examples of the magnesium compound represented by the general formula (1) include the following Compounds No. 1 to No. 3.

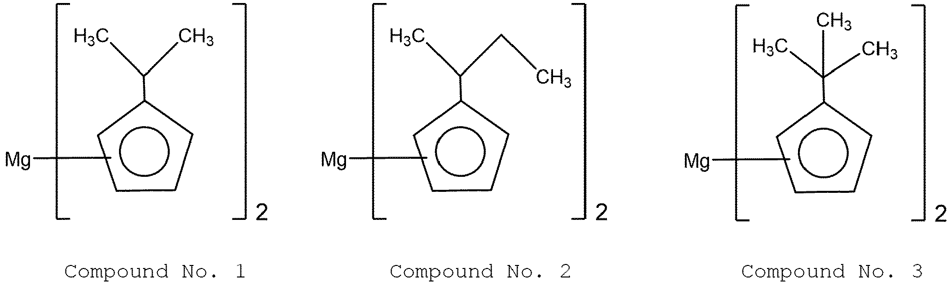

The magnesium compound represented by the general formula (1) is not particularly limited by a production method therefor, and may be produced by a well-known synthesis method. For example, the compound may be produced by a method involving a reaction among an alkylmagnesium chloride, 1,4-dioxane, and an alkylcyclopentadiene, a method involving a reaction between magnesium and an alkylcyclopentadiene, or the like. Specifically, Compound No. 2 may be produced by using n-butylmagnesium chloride, 1,4-dioxane, and sec-butylcyclopentadiene as raw materials through a reaction shown in the following formula (2).

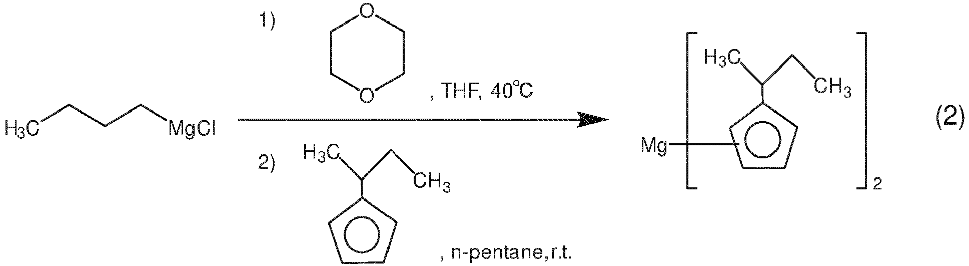

In addition, Compound No. 1 may be produced by using magnesium and isopropylcyclopentadiene as raw materials through a reaction shown in the following formula (3).

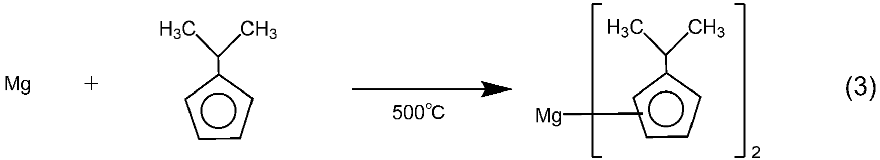

It is only required that the thin-film forming raw material, which is used in an atomic layer deposition method of the present invention, contain the magnesium compound represented by the general formula (1), and the composition thereof varies depending on the kind of an intended thin-film. For example, when a thin-film containing only magnesium as a metal is produced, the thin-film forming raw material, which is used in an atomic layer deposition method of the present invention is free of a metal compound other than the magnesium compound represented by the general formula (1) and a semimetal compound. Meanwhile, when a thin-film containing magnesium and a metal other than magnesium and/or a semimetal is produced, the thin-film forming raw material, which is used in an atomic layer deposition method of the present invention, may also contain a compound containing a metal other than magnesium and/or a compound containing a semimetal (hereinafter sometimes referred to as "other precursor") in addition to the magnesium compound represented by the general formula (1). The thin-film forming raw material, which is used in an atomic layer deposition method of the present invention may further contain an organic solvent and/or a nucleophilic reagent as described later.

The form of the thin-film forming raw material, which is used in an atomic layer deposition method of the present invention, is appropriately selected by a procedure, such as a transportation and supply method of the atomic layer deposition method to be used.

As the above-mentioned transportation and supply method, there are given a gas transportation method and a liquid transportation method. The gas transportation method involves heating and/or decompressing the thin-film forming raw material, which is used in an atomic layer deposition method of the present invention, and stored in a container (hereinafter sometimes simply referred to as "raw material container"), to thereby vaporize the raw material to obtain vapor, and introducing the vapor into a film formation chamber (hereinafter sometimes referred to as "deposition reaction portion") having a substrate set therein together with a carrier gas, such as argon, nitrogen, or helium, to be used as required. The liquid transportation method involves transporting the thin-film forming raw material, which is used in an atomic layer deposition method of the present invention, to a vaporization chamber under a state of a liquid or a solution, heating and/or decompressing the raw material in the vaporization chamber, to thereby vaporize the raw material to obtain vapor, and introducing the vapor into the film formation chamber. In the case of the gas transportation method, the magnesium compound represented by the general formula (1) itself may be used as the thin-film forming raw material, which is used in an atomic layer deposition method. In the case of the liquid transportation method, the magnesium compound represented by the general formula (1) itself or a solution obtained by dissolving the magnesium compound in an organic solvent may be used as the thin-film forming raw material, which is used in an atomic layer deposition method. Those raw materials for thin-film formation for an atomic layer deposition method may further contain the other precursor, a nucleophilic reagent, and the like.

In addition, in a multi-component ALD method, there are given a method involving vaporizing and supplying the thin-film forming raw material, which is used in an atomic layer deposition method independently for each component (hereinafter sometimes referred to as "single source method"), and a method involving vaporizing and supplying a mixed raw material obtained by mixing a multi-component raw material with a desired composition in advance (hereinafter sometimes referred to as "cocktail source method"). In the case of the cocktail source method, a mixture of the magnesium compound represented by the general formula (1) and the other precursor or a mixed solution obtained by dissolving the mixture in an organic solvent may be used as the thin-film forming raw material, which is used in an atomic layer deposition method. The mixture or the mixed solution may further contain a nucleophilic reagent and the like.

There is no particular limitation on the above-mentioned organic solvent, and a well-known general organic solvent may be used. Examples of the organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof depending on the solubility of a solute, the relationship among the use temperature, the boiling point, and the flash point, and the like. When those organic solvents are used, it is preferred that the amount of the entire precursors in the raw material which is a solution obtained by dissolving the precursors in the organic solvent be from 0.01 mol/liter to 2.0 mol/liter, particularly from 0.05 mol/liter to 1.0 mol/liter. When the thin-film forming raw material, which is used in an atomic layer deposition method of the present invention, is free of a metal compound other than the magnesium compound represented by the general formula (1) and a semimetal compound, the amount of the entire precursors refers to the amount of the magnesium compound. When the raw material for thin-film formation for an atomic layer deposition method of the present invention contains a compound containing another metal and/or a compound containing a semimetal (other precursor) in addition to the magnesium compound, the amount of the entire precursors refers to the total amount of the magnesium compound and the other precursor.

In addition, in the case of the multi-component ALD method, there is no particular limitation on the other precursor to be used together with the magnesium compound represented by the general formula (1), and well-known general precursors used in the thin-film forming raw material, which is used in an atomic layer deposition method may be used.

Examples of the other precursor include compounds of one kind or two or more kinds selected from the group consisting of compounds used as organic ligands, such as an alcohol compound, a glycol compound, a β-diketone compound, a cyclopentadiene compound, and an organic amine compound, and silicon or a metal. In addition, examples of the kind of the metal in the precursor include lithium, sodium, potassium, calcium, strontium, barium, titanium, zirconium, hafnium, vanadium, niobium, tantalum, chromium, molybdenum, tungsten, manganese, iron, ruthenium, cobalt, rhodium, iridium, nickel, palladium, platinum, copper, silver, gold, zinc, aluminum, gallium, indium, germanium, tin, lead, antimony, bismuth, scandium, ruthenium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the above-mentioned other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-s-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the above-mentioned other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

In addition, examples of the β-diketone compound include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β -diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

In addition, examples of the cyclopentadiene compound include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, and tetramethylcyclopentadiene, and examples of the organic amine compound to be used as the above-mentioned organic ligand include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The above-mentioned other precursors are known in the art, and production methods therefor are also known. One example of the production methods is given as described below. For example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal, and examples of the alkali metal alkoxide may include a sodium alkoxide, a lithium alkoxide, and a potassium alkoxide.

In the case of the single source method, the above-mentioned other precursor is preferably a compound which is similar to the magnesium compound represented by the general formula (1) in the behavior of thermal decomposition and/or oxidative decomposition. In the case of the cocktail source method, the above-mentioned other precursor is preferably a compound which is similar to the magnesium compound represented by the general formula (1) in the behavior of thermal decomposition and/or oxidative decomposition, and also does not cause alternation through a chemical reaction or the like at the time of mixing.

In addition, the thin-film forming raw material, which is used in an atomic layer deposition method of the present invention, may contain a nucleophilic reagent as required in order to improve the stability of the magnesium compound represented by the general formula (1) and the other precursor. Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane. The usage amount of each of those nucleophilic reagents falls within preferably a range of from 0.1 mol to 10 mol, more preferably a range of 1 mol to 4 mol with respect to 1 mol of the amount of the entire precursors.

The thin-film forming raw material, which is used in an atomic layer deposition method of the present invention, is prevented from containing impurity metal elements other than the components forming the raw material, impurity halogens, such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, or a barrier layer of an LSI, it is required to reduce the contents of alkali metal elements and alkaline-earth metal elements that influence the electrical characteristics of a thin-film to be obtained. The content of the impurity halogens is preferably 100 ppm or less, more preferably 10 ppm or less, most preferably 1 ppm or less. The total content of the impurity organic substances is preferably 500 ppm or less, more preferably 50 ppm or less, most preferably 10 ppm or less. In addition, moisture causes generation of particles in the thin-film forming raw material, which is used in an atomic layer deposition method, and generation of particles during thin-film formation, and hence it is better to remove moisture in the precursor, the organic solvent, and the nucleophilic reagent as much as possible in advance at the time of use in order to reduce moisture in each of the precursor, the organic solvent, and the nucleophilic reagent. The moisture content of each of the precursor, the organic solvent, and the nucleophilic reagent is preferably 10 ppm or less, more preferably 1 ppm or less.

In addition, it is preferred that the thin-film forming raw material, which is used in an atomic layer deposition method of the present invention, be prevented from containing particles to the extent possible in order to reduce or prevent particle contamination of a thin-film to be formed. Specifically, in particle measurement with a light scattering liquid particle detector in a liquid phase, it is preferred that the number of particles larger than 0.3 µm be 100 or less in 1 mL of the liquid phase, it is more preferred that the number of particles larger than 0.2 µm be 1,000 or less in 1 mL of the liquid phase, and it is most preferred that the number of particles larger than 0.2 µm be 100 or less in 1 mL of the liquid phase.

A method of producing a thin-film of the present invention is a method of producing a thin-film containing a magnesium atom on a surface of a substrate. The method is characterized by including the steps of: vaporizing the above-mentioned thin-film forming raw material, which is used in an atomic layer deposition method, and depositing the resultant on the surface of the substrate, to thereby form a precursor thin-film; and subjecting the precursor thin-film to a reaction with a reactive gas, to thereby form the thin-film containing a magnesium atom on the surface of the substrate.

As a material for the substrate, there are given, for example: silicon; ceramics, such as silicon nitride, titanium nitride, tantalum nitride, titanium oxide, titanium nitride, ruthenium oxide, zirconium oxide, hafnium oxide, and lanthanum oxide; glass; and metals, such as metal cobalt. The shape of the substrate is, for example, a plate shape, a spherical shape, a fibrous shape, or a scaly shape. The surface of the substrate may be planar, or may have a three-dimensional structure, such as a trench structure.

In addition, as a method of introducing vapor obtained by vaporizing the thin-film forming raw material, which is used in an atomic layer deposition method, into the film formation chamber in which the substrate is installed, there are given the above-mentioned gas transportation method, liquid transportation method, single source method, cocktail source method, and the like.

Examples of the reactive gas include: oxidizing gases, including oxygen, ozone, nitrogen dioxide, nitrogen monoxide, water vapor, hydrogen peroxide, formic acid, acetic acid, and acetic anhydride; reducing gases, including hydrogen; and nitriding gases, including organic amine compounds, such as a monoalkylamine, a dialkylamine, a trialkylamine, and an alkylenediamine, hydrazine, and ammonia. Those reactive gases may be used alone or as a mixture thereof. The thin-film forming raw material, which is used in an atomic layer deposition method of the present invention, has properties of reacting with, of those, oxidizing gases at specifically low temperature, in particular, reacting with ozone and water vapor at low temperature. From the viewpoint that a film thickness obtained per cycle is large, and a thin-film can be produced with high productivity, a gas containing ozone or water vapor is preferably used as the reactive gas, and a gas containing water vapor is more preferably used.

As conditions for the above-mentioned production, there are further given a temperature and a pressure when the raw material for thin-film formation for an atomic layer deposition method is vaporized to obtain vapor. The step of vaporizing the thin-film forming raw material, which is used in an atomic layer deposition method to obtain vapor may be performed in the raw material container or in the vaporization chamber. In any case, it is preferred that the thin-film forming raw material, which is used in an atomic layer deposition method of the present invention be evaporated at a temperature of from 0°C to 200°C. In addition, when the thin-film forming raw material, which is used in an atomic layer deposition method, is vaporized to obtain vapor in the raw material container or in the vaporization chamber, the pressure in the raw material container and the pressure in the vaporization chamber are both preferably from 1 Pa to 10,000 Pa.

There is no particular limitation on the production conditions in the method of producing a thin-film of the present invention. For example, the reaction temperature (substrate temperature), the reaction pressure, the deposition rate, and the like may be appropriately determined in accordance with the desired thickness and kind of a thin-film. The reaction temperature is preferably 100°C or more, which is the temperature at which the thin-film forming raw material, which is used in an atomic layer deposition method of the present invention, sufficiently reacts, more preferably from 150°C to 400°C, and the thin-film forming raw material, which is used in an atomic layer deposition method of the present invention is used within the ALD window matched to the reactive gas. The film thickness is controlled by the number of cycles so as to obtain a desired film thickness.

Now, regarding each step of the ALD method, the case of forming a magnesium oxide thin-film is described in detail as an example. First, vapor of a thin-film forming raw material, which is used in an atomic layer deposition method, is introduced into a film formation chamber (raw material introduction step). The preferred temperature and pressure when the thin-film forming raw material, which is used in an atomic layer deposition method, is turned into vapor fall within a range of from 0°C to 200°C and a range of from 1 Pa to 10,000 Pa, respectively. Next, the vapor introduced into the film formation chamber is deposited on the surface of a substrate, to thereby form a precursor thin-film on the surface of the substrate (precursor thin-film formation step). In this case, heat may be applied by heating the substrate or heating the film formation chamber. The temperature of the substrate when this step is performed is preferably from room temperature to 500°C, more preferably from 150°C to 400°C. The ALD window when the thin-film forming raw material, which is used in an atomic layer deposition method of the present invention, and an oxidizing gas are used in combination falls within a range of from about 200° to about 400°C. The pressure of a system (in the film formation chamber) when this step is performed is preferably from 1 Pa to 10,000 Pa, more preferably from 10 Pa to 1,000 Pa.

Next, vapor of the thin-film forming raw material, which is used in an atomic layer deposition method remaining unreacted and a gas generated as a by-product are evacuated from the film formation chamber (evacuation step). It is ideal that the vapor of the thin-film forming raw material, which is used in an atomic layer deposition method and is remaining unreacted, and the gas generated as a by-product be completely evacuated from the film formation chamber, but it is not always required that the vapor and the by-product gas be completely evacuated. As an evacuation method, there are given, for example, a method involving purging the inside of the system with an inert gas, such as nitrogen, helium, and argon, a method involving performing evacuation by decompressing the inside of the system, and a combination of these methods. The decompression degree when decompression is performed is preferably from 0.01 Pa to 300 Pa, more preferably from 0.01 Pa to 100 Pa.

Next, an oxidizing gas is introduced as a reactive gas into the film formation chamber, and a magnesium oxide thin-film is formed from the precursor thin-film formed in the previous precursor thin-film formation step through the action of the oxidizing gas or the action of the oxidizing gas and heat (magnesium oxide thin-film formation step). In this step, the temperature when the heat is applied is preferably from room temperature to 500°C, more preferably from 150°C to 400°C. The ALD window when the thin-film forming raw material, which is used in an atomic layer deposition method of the present invention and the oxidizing gas are used in combination falls within a range of from about 200°C to about 400°C, and hence it is most preferred that the precursor thin-film be subjected to a reaction with the oxidizing gas at a temperature within a range of from 200°C to 400°C. The pressure of the system (in the film formation chamber) when this step is performed is preferably from 1 Pa to 10,000 Pa, more preferably from 10 Pa to 1,000 Pa. The thin-film forming raw material, which is used in an atomic layer deposition method of the present invention, has satisfactory reactivity with the oxidizing gas, and thus a high-quality magnesium oxide-containing thin-film containing less residual carbon can be produced with high productivity.

In the method of producing a thin-film of the present invention, thin-film deposition performed by a series of operations including the above-mentioned raw material introduction step, precursor thin-film formation step, evacuation step, and metal oxide-containing thin-film formation step is defined as one cycle, and this cycle may be repeated a plurality of times until a thin-film having a required film thickness is obtained. In this case, it is preferred that, after one cycle is performed, an unreacted reactive gas (oxidizing gas when a magnesium oxide-containing thin-film is formed) and a gas generated as a by-product be evacuated from the film formation chamber in the same manner as in the above-mentioned evacuation step, and the subsequent one cycle be performed.

In addition, in the method of producing a thin-film of the present invention, energy, such as plasma, light, or a voltage, may be applied, and a catalyst may be used. There is no particular limitation on the timing for applying the energy and the timing for using the catalyst. The energy may be applied or the catalyst may be used, for example, at the time of introducing the vapor of the thin-film forming raw material, which is used in an atomic layer deposition method in the raw material introduction step, at the time of heating in the precursor thin-film formation step or the magnesium oxide-containing thin-film formation step, at the time of evacuating the inside of the system in the evacuation step, or at the time of introducing the oxidizing gas in the magnesium oxide-containing thin-film formation step, or between the above-mentioned respective steps.

In addition, in the method of producing a thin-film of the present invention, after the thin-film formation, annealing treatment may be performed in an inert atmosphere, an oxidizing atmosphere, or a reducing atmosphere in order to obtain more satisfactory electrical characteristics. When step embedding is required, a reflow step may be provided. The temperature in this case is from 200°C to 1,000°C, preferably from 250°C to 500°C.

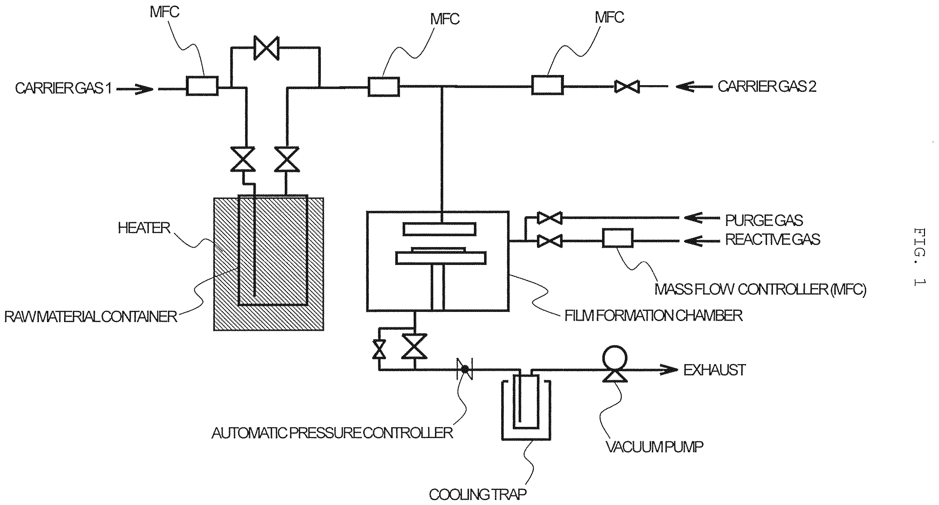

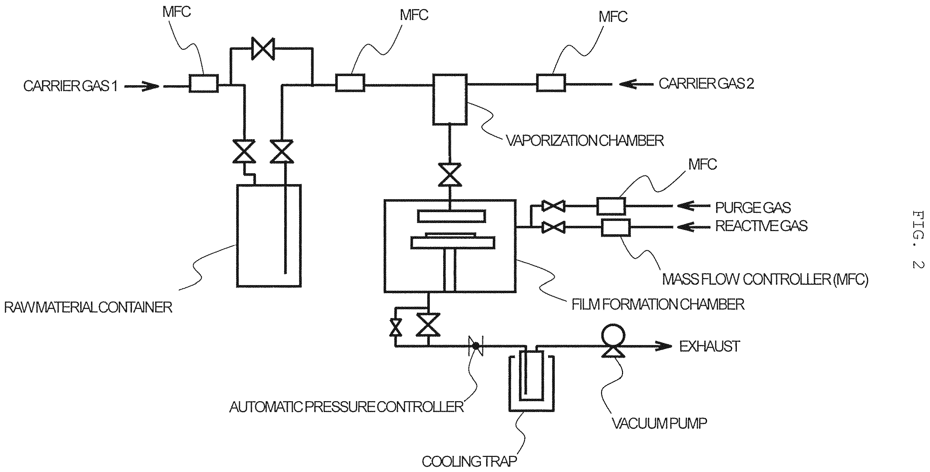

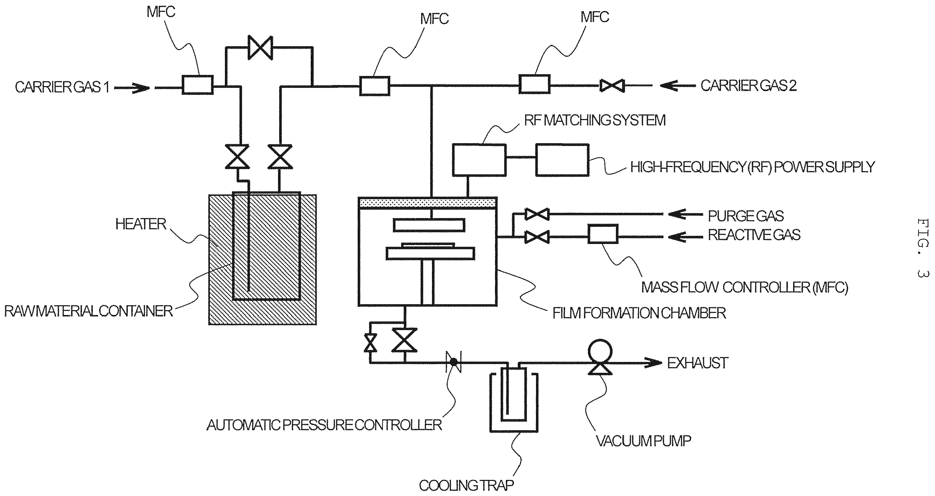

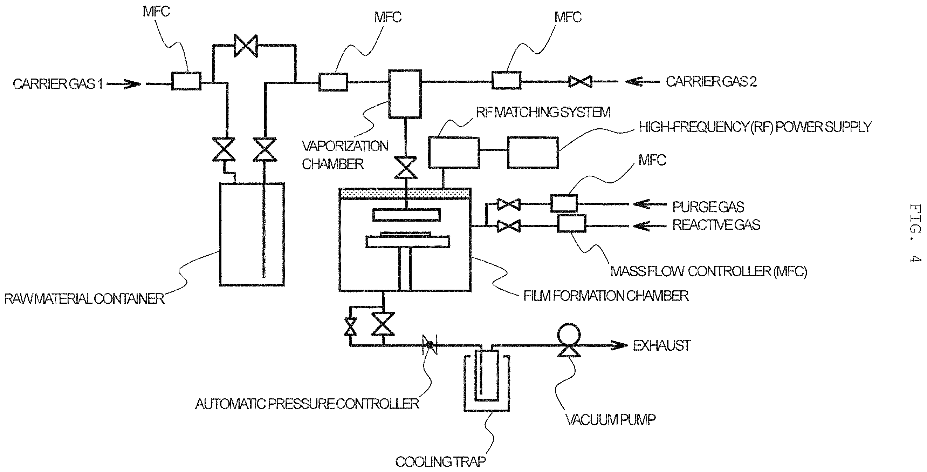

As an apparatus for producing a thin-film through use of the thin-film forming raw material, which is used in an atomic layer deposition method of the present invention, a well-known apparatus for an atomic layer deposition method may be used. As specific examples of the apparatus, there are given an apparatus capable of performing bubbling supply of a precursor as illustrated in FIG. 1 and an apparatus including a vaporization chamber as illustrated in FIG. 2. In addition, there is given an apparatus capable of subjecting the reactive gas to plasma treatment as illustrated in FIG. 3 and FIG. 4. The apparatus is not limited to single-substrate type apparatus as illustrated in FIG. 1 to FIG. 4, and an apparatus capable of simultaneously processing a large number of substrates through use of a batch furnace may also be used.

A thin-film produced through use of the thin-film forming raw material, which is used in an atomic layer deposition method of the present invention may be formed as desired kinds of thin-films, such as thin-films of a metal, oxide ceramics, nitride ceramics, and glass, by appropriately selecting the other precursor, the reactive gas, and the production conditions. It has been known that the thin-films exhibit electrical characteristics, optical characteristics, and the like, and the thin-films are used for various applications. For example, those thin-films have been widely used for the production of, for example, electrode materials for memory elements typified by DRAM elements, resistance films, diamagnetic films used for recording layers of hard disks, and catalyst materials for polymer electrolyte fuel cells.

### Examples

Now, the present invention is described in more detail by way of production examples, evaluation examples, Examples, and Comparative Examples. However, the present invention is not limited by the following Examples and the like.

### [Production Example 1] Synthesis of Compound No. 2

112.5 mL of a THF solution (2 mol/L) of n-butylmagnesium chloride was added to a 1 L four-necked flask, and 58 mL of 1,4-dioxane was added thereto. The mixture was heated and stirred at 40°C for 2 hours. 250 mL of n-pentane was added to the reaction solution at room temperature (20°C), and after that, 38.2 g of sec-butylcyclopentadiene was added dropwise. The resultant was stirred at room temperature for 19 hours. Then, the obtained suspension was filtered, and the solvent was removed in an oil bath at 90°C under reduced pressure. The generated magnesium complex was distilled in an oil bath at 120°C and 45 Pa to obtain Compound No. 2 as a pale yellow transparent liquid (yield: 22.06 g, percent yield: 73.5%).

### (Analytic Values)

(1) Normal-pressure TG-DTA
   50% mass loss temperature: 202°C (760 Torr, Ar flow rate: 100 mL/min, temperature increase rate: 10°C/min)
(2) Reduced-pressure TG-DTA
   50% mass loss temperature: 121.8°C (10 Torr, Ar flow rate: 50 mL/min, temperature increase rate: 10°C/min)
(3) ¹H-NMR (deuterated benzene)
   0.83-0.86 ppm (3H, triplet), 1.22-1.24 ppm (3H, doublet), 1.38-1.63 ppm (2H, multiplet), 2.50-2.58 ppm (1H, multiplet), 5.87-5.90 ppm (2H, multiplet), 5.97-6.02 ppm (2H, multiplet)

### [Evaluation Example 1 and Comparative Evaluation Example 1]

### Evaluation of Physical Properties of Magnesium Compound

Compound No. 2 obtained in Production Example 1 and the following comparative compound 1 were heated to check each reaction start temperature under the conditions of a normal-pressure atmosphere (760 torr) and an oxygen flow rate of 100 mL/min through use of a TG-DTA measuring device. A compound having a low reaction start temperature reacts with oxygen at low temperature, and hence can be determined to be preferred as a thin-film forming raw material, which is used in an atomic layer deposition method. In addition, each thermal decomposition occurrence temperature of Compound No. 2 obtained in Production Example 1 and the following comparative compound 1 was measured through use of a DSC measuring device. A compound having a high thermal decomposition occurrence temperature is less liable to undergo thermal decomposition, and hence can be determined to be preferred as a thin-film forming raw material, which is used in an atomic layer deposition method.

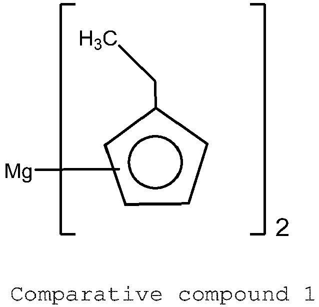

**Table 1**

| | Magnesium Reaction start compound temperature (° C) | | Thermal decomposition occurrence temperature (° C) |
|---|---|---|---|
| Evaluation Example 1 | Compound No. 2 | 200 | 380 |
| Comparative Evaluation Example 1 | Comparative compound 1 | 230 | 340 |

It was found from the results in Table 1 that Compound No. 2 reacted with oxygen at a temperature lower than that of the comparative compound 1 by 30°C. In addition, it was found that Compound No. 2 had thermal stability higher than that of the comparative compound 1 by 40°C. It was found that the magnesium compound represented by the general formula (1) according to the present invention was particularly suitable as a thin-film forming raw material, which is used in an atomic layer deposition method as compared to the comparative compound having a similar structure.

### [Example 1] Production of Magnesium Oxide Thin Film

A magnesium oxide thin-film was produced on a silicon wafer by the ALD method under the following conditions through use of the apparatus illustrated in FIG. 1 with Compound No. 2 being used as a thin-film forming raw material, which is used in an atomic layer deposition method. When the composition of the obtained thin-film was checked by X-ray photoelectron spectroscopy, the obtained thin-film was magnesium oxide, and the residual carbon content was less than 1.0 atom%. In addition, when the film thickness was measured by an X-ray reflectivity method, and the average value thereof was calculated, the average film thickness was 51.0 nm, and the average film thickness obtained per cycle was 0.17 nm.

### (Conditions)

Substrate: silicon wafer, reaction temperature (silicon wafer temperature): 300°C, reactive gas: water vapor
A series of steps including the following (1) to (4) was defined as one cycle, and this cycle was repeated 300 times.
(1) A raw material for an atomic layer deposition method vaporized under the conditions of a raw material container temperature of 80°C and a raw material container internal pressure of 100 Pa is introduced into a film formation chamber and deposited at a system pressure of 100 Pa for 30 seconds.
(2) The raw material which has not been deposited is removed through argon purging for 15 seconds.
(3) A reactive gas is introduced into the film formation chamber and subjected to a reaction at a system pressure of 100 Pa for 0.1 second.
(4) An unreacted reactive gas and a by-product gas are removed through argon purging for 60 seconds.

### [Comparative Example 1] Production of Magnesium Oxide Thin Film

A magnesium oxide thin-film was produced under the same conditions as those in Example 1 except that the comparative compound 1 was used as the raw material for an atomic layer deposition method. When the composition of the obtained thin-film was checked by X-ray photoelectron spectroscopy, the obtained thin-film was magnesium oxide, and the residual carbon content was less than 1.0 atom%. In addition, when the film thickness was measured by the X-ray reflectivity method, and the average value thereof was calculated, the average film thickness was 36.0 nm, and the average film thickness obtained per cycle was 0.12 nm.

It was found from the results in Example 1 and Comparative Example 1 that, in Example 1, the film thickness obtained per cycle was 1.4 times or more as large as that of Comparative Example 1, and a high-quality magnesium oxide thin-film was able to be obtained with high productivity.

As described above, according to the present invention, it can be said that a high-quality magnesium oxide thin-film can be produced with high productivity.

The present international application claims priority based on Japanese Patent Application No. 2018-081484 filed on April 20, 2018, the contents of which are incorporated herein by reference in their entirety.

## Claims

1. A thin-film forming raw material, which is used in an atomic layer deposition method, comprising a magnesium compound represented by the following general formula (1): 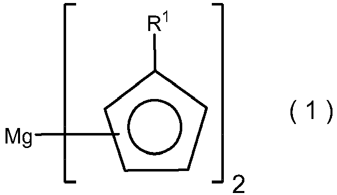 where R¹ represents an isopropyl group, a sec-butyl group, or a tert-butyl group.

2. A method of producing a thin-film containing a magnesium atom on a surface of a substrate,
the method comprising the steps of:
vaporizing the thin-film forming raw material of claim 1, which is used in an atomic layer deposition method and depositing the thin-film forming raw material, which is used in an atomic layer deposition method on the surface of the substrate, to thereby form a precursor thin-film; and
subjecting the precursor thin-film to a reaction with a reactive gas, to thereby form the thin-film containing a magnesium atom on the surface of the substrate.

3. The method of producing a thin-film according to claim 2, wherein the reactive gas is an oxidizing gas, and wherein the thin-film is magnesium oxide.

4. The method of producing a thin-film according to claim 3, wherein the oxidizing gas is a gas containing ozone or water vapor.

5. The method of producing a thin-film according to claim 3 or 4, wherein the step of subjecting the precursor thin-film to a reaction with the reactive gas is performed at a temperature within a range of from 200°C to 400°C.
